# EUROPEAN PATENT SPECIFICATION

(11) **EP 2 378 838 B1**
(45) Date of publication and mention of the grant of the patent: **11.06.2014**
(21) Application number: 11161345.1
(22) Date of filing: 06.04.2011
(51) Int. Cl.: H05B 33/02, H05B 33/10, H05B 33/14

(54) **Wavelength converting member and illumination device using the same**
Wellenlängenkonvertierendes Element und Beleuchtungsvorrichtung damit
Élément de conversion de la longueur d'onde et dispositif d'éclairage l'utilisant

(30) Priority: 16.04.2010 JP 2010095242
(43) Date of publication of application: 19.10.2011
(73) Proprietor: Panasonic Corporation, Osaka 571-8501 (JP)
(72) Inventor: Takei, Naoko, Osaka (JP)
(74) Representative: Rüger, Barthelt & Abel

(56) References cited:
- EP-A2- 0 239 991
- US-A- 5 660 573
- US-A- 5 976 613

## Description

### [Field of the Invention]

The present invention relates to a wavelength converting member and an illumination device using the same.

### [Background Art]

Along with the wide spread of an illumination device that achieves white light by combining, for example, a light emitting element such as an LED (light emitting diode) and a phosphor that is excited by light emitted from the light emitting element to emit light having a different wavelength, there is an increasing demand to change a color temperature of illumination light in the same space to meet a life scene that is diversifying.

In order to meet such a demand, there is proposed an illumination device in which an optical filter is disposed oppositely to light emitting surfaces of light emitting elements (e.g., see Patent literature 1). This illumination device is configured such that the above optical filter is provided with a plurality of types of filtering function parts respectively having different filtering characteristics, and by switching a filtering function part to face to the light emitting elements, a color temperature of illumination light can be changed.

### [Conventional Technique Literature]

### [Patent Literature]

[Patent literature1] JP 2005-347280A (paragraphs [0031] and [0032], and Figs. 3 and 4)
[Patent literature 2] Document US 5660573 discloses electroluminescent lamps comprising a structure of successive layers including insulating layers and a phosphor layer. The insulating area is provided in such a way, that a change in thickness is produced and a corresponding change in the electric field across the phosphor layer. (Col.2-5; figures)

### [Disclosure of the Invention]

### [Problems to be solved by the Invention]

In the illumination device described in above Patent literature 1, by switching the filtering function part, the color temperature of the illumination light can be changed; however, a site between the filtering function parts blocks the illumination light, which may cause a user to feel a sense of discomfort, and as the number of patterns according to which the color temperature is changed is increased, the number of filtering function parts should be increased, so that the optical filter is increased in size, and along with this, the illumination device is also increased in size.

The present invention is made in consideration of the above problems, and has an object to provide a wavelength converting member that can continuously change a color temperature of incident light, and a small sized illumination device using the wavelength converting member.

### [Means adapted to solve the Problems]

A wavelength converting member of the present invention is provided with: a phosphor layer provided with a phosphor that converts at least part of incident light to light having a different wavelength, and a binder that holds the phosphor; and thickness changing means adapted to change a thickness of the phosphor layer in an incident direction of the light.

In the wavelength converting member, preferably, the phosphor is uniformly dispersed inside the phosphor layer.

Also, in the wavelength converting member, preferably, the thickness changing means has a plurality of substrates that hold the phosphor layer in between, and changes an interval between the substrates to thereby change the thickness of the phosphor layer in the incident direction.

Further, in the wavelength converting member, preferably, a plurality of phosphor layers are provided, and arranged so as to overlap with each other in the incident direction.

Also, in the wavelength converting member, preferably, a plurality of phosphor layers are provided, and arranged so as not to overlap with each other in the incident direction.

Further, in the wavelength converting member, preferably, part of light emitted from a phosphor layer arranged in a position close to an incident surface is absorbed by a phosphor layer arranged in a position distant from the incident surface, and from the phosphor layer, light having a different wavelength is emitted.

An illumination device of the present invention is provided with: a light emitting diode; and any of the above wavelength converting members, which converts at least part of incident light from the light emitting diode to light having a different wavelength.

### [Effect of the Invention]

There are effects of being able to continuously change a color temperature of incident light by a wavelength converting member, and further, decreasing the illumination device in size by using the wavelength converting member.

### [Brief Description of the Drawings]

[Fig. 1] Fig. 1 is a schematic configuration diagram of an illumination device using a wavelength converting member of a first embodiment with partially omitting the illumination device.
[Fig. 2] Figs. 2 (a) and (b) are explanatory diagrams for explaining operation of the illumination device.
[Fig. 3] Fig. 3 is a graph for explaining the operation of the illumination device.
[Fig. 4] Figs. 4 (a) and (b) are explanatory diagrams for explaining operation of an illumination device using a wavelength converting member of a second embodiment.
[Fig. 5] Fig. 5 is a graph for explaining the operation of the illumination device.

### [Best Mode for Carrying Out the Invention]

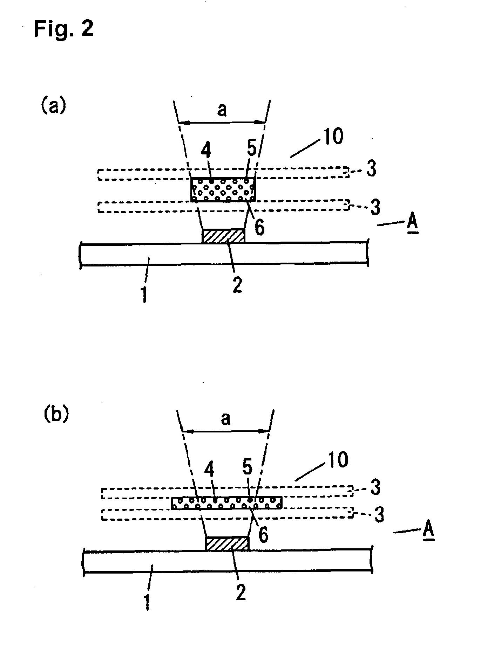

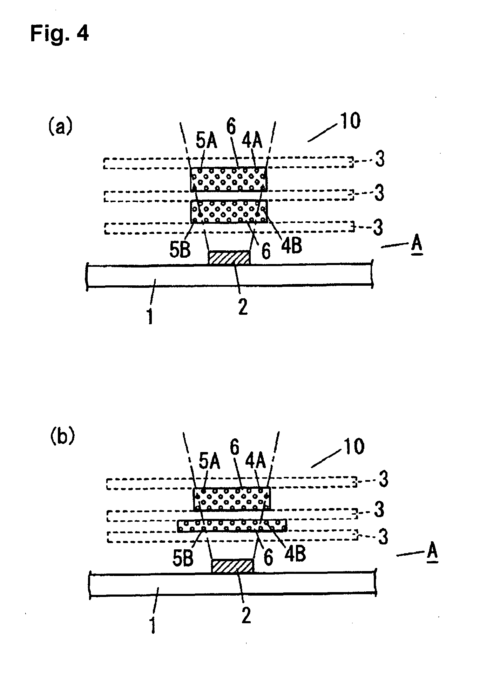

Embodiments of a wavelength converting member according to the present invention and an illumination device using the wavelength converting member are described on the basis of the drawings. The wavelength converting member according to the present invention is one that is used to change a color temperature of incident light from a light emitting element such as an LED (light emitting diode), and by combining the wavelength converting member and the light emitting element, the illumination device according to the present invention is configured. Note that, in the following description, the case of using the light emitting element as a light source is described; however, the light source is not limited to the light emitting element, but another light source such as a fluorescent lamp or incandescent light is also possible. Also, in Figs. 2 and 4, for simplification of the illustrations, illustration of a drive circuit is omitted.

### (First embodiment)

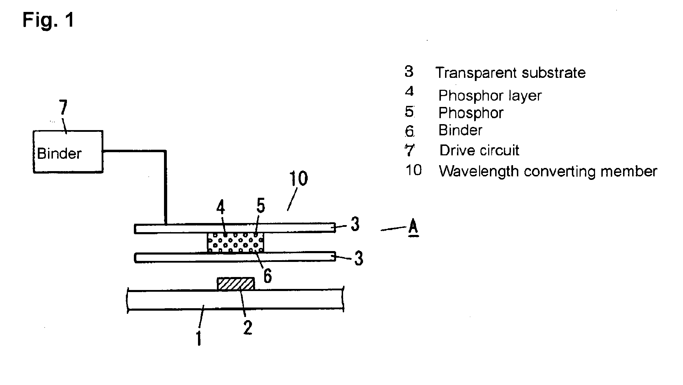

Fig. 1 is a schematic configuration diagram of an illumination device A of the present embodiment with partially omitting the illumination device A, and the illumination device A is provided with a light emitting element 2, and a wavelength converting member 10 that changes a color temperature of incident light from the light emitting element 2.

The light emitting element 2 is, for example, a blue light emitting diode (e.g., GaN based semiconductor or the like) that emits blue light having a peak wavelength of 430 to 490 nm, and formed of a layered film in which, for example, Ni and Au films, and other films are stacked. Also, on a surface of the light emitting element 2, anode and cathode electrodes are formed, and each of them is electrically connected to a substrate 1 with use of an Au bump. Note that a material for the light emitting element 2 is not limited to the above-described Ni or Au film, but any other material may be used if a good ohmic characteristic can be obtained.

On the other hand, the substrate 1 is an alumina ceramic substrate having a wiring pattern of which a nearest surface is plated with Au, in which the above wiring pattern is continuously formed also on a side surface of the substrate, and a reflow pattern is formed also on a back surface of the substrate. The substrate 1 is mounted on an unillustrated wiring board in a solder reflow process. The light emitting element 2 may be mounted on the surface of the substrate as illustrated in Fig. 1, or may be mounted, for example, in a concave portion provided on the surface of the substrate. Also, the substrate 1 may be made of, for example, AIN (aluminum nitride).

The wavelength converting member 10 is provided with: a phosphor layer 4; a plurality of (in the diagram, two) transparent substrates 3 and 3 that hold the phosphor layer 4 from both of upper and lower sides; and a drive circuit 7 that moves one (upper one in Fig. 1) of the transparent substrates 3 with respect to the other transparent substrate 3 in a vertical direction such that the one transparent substrate 3 can advance or retreat.

The phosphor layer 4 is provided with: a phosphor 5 that converts the incident light (in this embodiment, blue light) from the light emitting element 2 to light having a different wavelength (after-mentioned yellow light having a longer peak wavelength, or green light and red light having longer peak wavelengths); and a binder 6 that holds the phosphor 5.

The phosphor 5 absorbs the blue light having a peak wavelength of, for example, 430 to 490 nm, and emits the light having the longer peak wavelength than that of the blue light, such as the green, yellow, or red light. For example, in order to obtain white light, as the phosphor 5, it is only necessary to select a yellow phosphor that emits yellow light, whereas in order to obtain white color having higher color rendering properties, it is only necessary to use a green phosphor emitting green light and a red phosphor emitting red light in combination. At this time, if a phosphor layer is a single layer as in the present embodiment, it is only necessary to use the green and red phosphors with mixing them, or if the phosphor layer includes a plurality of layers as in a second embodiment to be described later, a mixing ratio between the green phosphor and the red phosphor in each of the phosphor layers may be changed, or a phosphor layer including the green phosphor and a phosphor layer including the red phosphor may be separately formed. Note that regarding an amount of the phosphor 5 to be dispersed in the phosphor layer 4, in a state where a thickness of the phosphor layer 4 is large, a concentration is adjusted so as to obtain a lowest color temperature within a color temperature adjustment range, or in the case of mixing a plurality of types of phosphors, a mixing ratio among them is adjusted.

The binder 6 is made of a transparent elastic material such as silicone resin or epoxy resin, and elastically deformed by pressure externally applied thereon. The higher the transmittance of the binder 6, the better the binder 6, and the binder 6 having a transmittance of 90 % or more is preferable. Also, elasticity of the binder 6 can be measured as a hardness, and quantified between a hardness of 0 and a hardness of 100, and as a value of the hardness is decreased, the binder 6 exhibits softer properties (i.e., higher elasticity). As a material for the binder 6, one having a hardness of 60 or less is preferable, and one having a hardness of 50 or less is more preferable.

In the present embodiment, inside the phosphor layer 4 formed with the binder 6, the phosphor 5 is substantially uniformly dispersed, and therefore a relationship between the thickness of the phosphor layer 4 in a light incident direction (vertical direction in Fig. 1) and the amount of the phosphor 5 is linear. Accordingly, by changing the thickness of the phosphor layer 4, an amount of light to be subjected to the wavelength conversion can be continuously changed, and as a result, a color temperature of the light that transmits through the wavelength converting member 10 and is emitted outside can be continuously changed. In addition, in the case of enhancing diffusivity of light, a diffusing material (such as one including an inorganic material such as aluminum oxide or silica, or one including an organic materials such as fluorine based resin) may be dispersed inside the phosphor layer 4.

The transparent substrate 3 is made of a transparent material such as a silicone resin, an acrylic resin, or a glass, and formed into a plate-like shape having a thin thickness. The thickness of the transparent substrate 3 is preferably thinned as much as possible from the perspective of transmittance; however, in the present embodiment, the transparent substrate 3 has a structure externally applied with pressure, and therefore the thickness is set to a thickness that is enough to prevent the transparent substrate 3 from being broken by the pressure. Also, the higher the transmittance of the transparent substrate 3, the better the transparent substrate 3, and the transparent substrate 3 having a transmittance of 90 % or more is preferable. Note that the present embodiment is adapted such that the external pressure is applied on the one (upper one in Fig. 1) of the transparent substrates 3 by the drive circuit 7, and as a result, the one transparent substrate 3 moves in the vertical direction with respect to the other transparent substrate 3 (lower one in Fig. 1) to be thereby able to change an interval between both of the transparent substrates 3 and 3. In the present embodiment, both of the transparent substrates 3 and 3 and the drive circuit 4 constitute thickness changing means adapted to change the thickness of the phosphor layer 4 in the vertical direction (light incident direction).

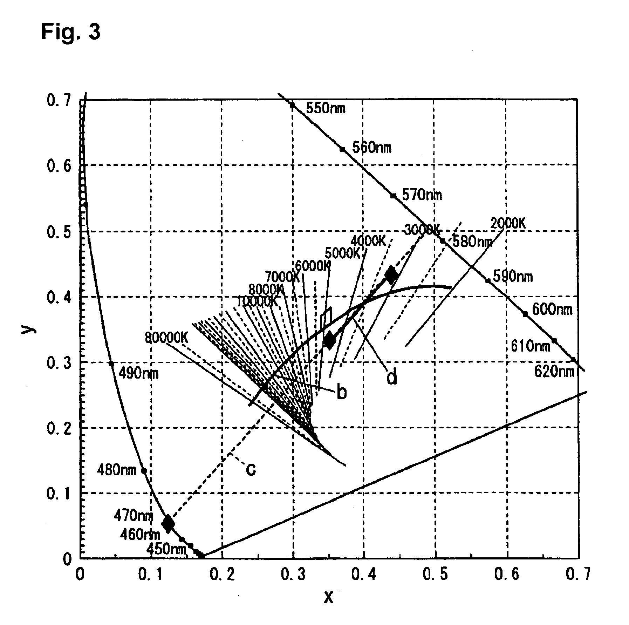

Fig. 3 is a graph illustrating a change in color temperature of the illumination device A of the present embodiment, and the light transmitting through the wavelength converting member 10 shifts on a line segment c connecting the color temperature of the emission color of the light emitting element 2 and a color temperature of a peak wavelength of the phosphor 5, but in practice, shifts within a range of a line segment d depending on the thickness of the phosphor layer 4. Note that a curve b in Fig. 3 represents a blackbody locus, and in the illumination device A of the present embodiment, the color temperature of the light transmitting through the wavelength converting member 10 changes with being displaced from the blackbody locus b.

Next, operation of the illumination device A of the present embodiment is described with reference to Fig. 2. When the blue light emitted from the light emitting element 2 transmits through the lower side transparent substrate 3 to enter the phosphor layer 4, part of the blue light entering the phosphor layer 4 is absorbed by the phosphor 5, and then converted to the yellow light having a longer peak wavelength, or the green and red lights having longer peak wavelengths. Then, the yellow light having a longer peak wavelength, or the green and red lights having longer peak wavelengths are mixed with remaining blue light in the phosphor layer 4 to form white light, which transmits through the upper side transparent substrate 3 and is emitted outside.

Note that Fig. 2 (a) illustrates a state where the interval between the transparent substrates 3 and 3 is expanded by the drive circuit 7, and in this case, the thickness of the phosphor layer 4 in the vertical direction (light incident direction) is increased to thereby increase the amount of the phosphor 5 positioned on a light axis of the light emitting element 2. That is, a ratio of the blue light converted in wavelength by the phosphor 5 is increased, and thereby white light close to yellow light is emitted outside.

On the other hand, Fig. 2 (b) illustrates a state where the interval between the transparent substrates 3 and 3 is narrowed by the drive circuit 7, and in this case, the thickness of the phosphor layer 4 in the vertical direction is decreased to thereby decrease the amount of the phosphor 5 positioned on the light axis of the light emitting element 2. That is, the ratio of the blue light converted in wavelength by the phosphor 4a is decreased, and thereby white light close to blue light is emitted outside. Note that when the pressure applied by the drive circuit 7 is released, the state is restored by the elastic force of the binder 6. A region a in Figs. 2 (a) and (b) represents an emission range of the light by the light emitting element 2.

Thus, according to the present embodiment, by changing the thickness of the phosphor layer 4 in the light incident direction (vertical direction in Fig. 1), the amount of the phosphor 5 in the same direction can be continuously changed, so that a ratio of the light converted in wavelength by the phosphor 5 can be continuously changed, and as a result, the color temperature of the incident light (light emitted from the light emitting element 2) can be continuously changed. Also, as compared with the case where as in the conventional example, by switching the filtering function part, the color temperature is changed, light spread in a direction orthogonal to the light incident direction can be suppressed, and as a result, the wavelength converting member 10 having a compact size can be provided.

Further, by constituting the thickness changing means with the transparent substrates 3 and 3 and the drive circuit 7 as in the present embodiment, the thickness changing means adapted to change the thickness of the phosphor layer 4 in the light incident direction can be realized with a simple configuration. Also, by using the above-described wavelength converting member 10, the small-sized illumination device A that can continuously change the color temperature of the incident light from the light emitting element 2 can be provided.

### (Second embodiment)

A second embodiment of the illumination device A according to the present invention is described below. In the first embodiment, the case where the phosphor layer is a single layer is described; however, in the present embodiment, the case where a phosphor layer includes a plurality of layers is described. Note that in the following description, the same components as those in the first embodiment are denoted by the same symbols, and description thereof is omitted. Also, in the following description, if it is not necessary to distinguish between phosphor layers 4A and 4B, they are collectively referred to as a phosphor layer 4.

An illumination device A of the present invention is provided with a light emitting element 2 and a wavelength converting member 10.

The wavelength converting member 10 is, as illustrated in Fig. 4 (a), provided with: a plurality of (in Fig. 4 (a), three) transparent substrates 3; and a plurality of (in Fig. 4 (a), two) phosphor layers 4A and 4B each of which is arranged between the transparent substrates 3 and 3. Each of the transparent substrates 3 and 3 arranged in upper and middle stages in Fig. 4 (a) can be moved in a vertical direction by an unillustrated drive circuit to individually adjust thicknesses of the respective phosphor layers 4A and 4B in the vertical direction. Note that, in the present embodiment, the respective phosphor layers 4A and 4B are arranged so as to overlap with each other in the vertical direction (light incident direction). Also, inside one 4A (e.g., upper side in Fig. 4 (a)) of the phosphor layers, a green phosphor 5A is substantially uniformly dispersed, and inside the other phosphor layer 4B, a red phosphor 5B is substantially uniformly dispersed.

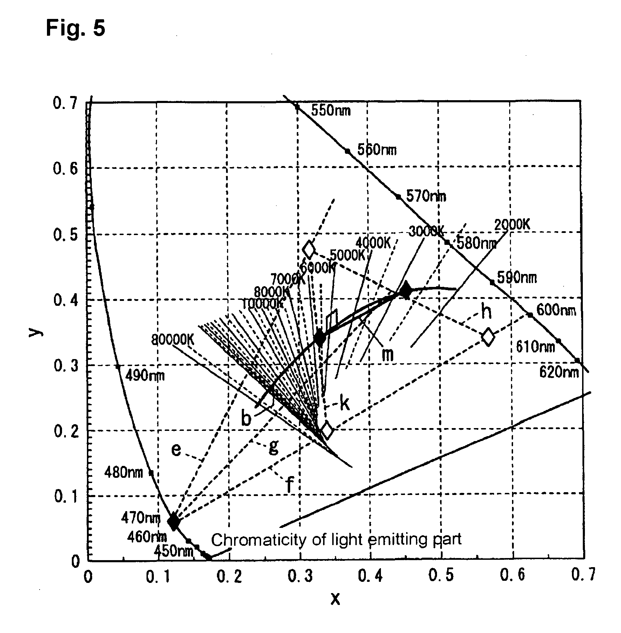

Fig. 5 is a graph illustrating a change in color temperature of the illumination device A of the present embodiment, and light transmitting through the wavelength converting part 10 shifts on a line segment e in the case of a single body of the phosphor layer 4A containing the green phosphor 5A, and in the case of a single body of the phosphor layer 4B containing the red phosphor 5B, shifts on a line segment f. Accordingly, if the thicknesses of the respective phosphor layers 4A and 4B are changed at the same rate, the light transmitting through the wavelength converting member 10 will shift on a line segment g between the line segments e and f, and in this case, change with being displaced from a blackbody locus b. For this reason, in the present embodiment, as illustrated in Fig. 4 (b), the thickness of the one phosphor layer 4A is kept constant, and only the thickness of the other phosphor layer 4B is changed. As a result, the color temperature of the present illumination device A shifts on a line segment m, and therefore the color temperature change close to the blackbody locus b can be achieved. Note that line segments h and k in Fig. 5 are auxiliary lines that are provided for convenience to obtain the loca of the color temperature change. Also, operation of the illumination device A is the same as that in the first embodiment, and therefore description thereof is omitted here.

Thus, according to the present embodiment, the plurality of phosphor layers 4A and 4B are provided, so that as compared with the case where the phosphor layer 4 is a single layer, a color variation can be expanded, and further by individually adjusting the thicknesses of the respective phosphor layers 4A and 4B, the color temperature change close to the blackbody locus b can be achieved. Also, by using the above-described wavelength converting member 10, the small-sized illumination device A that can continuously change the color temperature of the light emitted from the light emitting element 2 can be provided.

The illumination device A may be configured such that, as illustrated in Fig. 4 (a), out of the plurality of phosphor layers 4A and 4B arranged so as to overlap with each other in the light incident direction, part of light emitted from the phosphor layer 4B arranged in a position close to an incident surface (lower side in Fig. 4 (a)) is absorbed by the phosphor layer 4A arranged in a position distant from the incident surface (upper side in Fig. 4 (a)) to emit light having a wavelength different from a wavelength of the light. In this case, by the light emitted from the phosphor layer 4A arranged in the position distant from the incident surface, the color temperature variation can be brought closer to the blackbody locus b. In addition, it should be appreciated that, in this case, depending on the wavelength of the light absorbed by the phosphor layer 4A arranged in the position distant from the incident surface, a locus along which the color temperature of the light is changed is different.

Note that, in the present embodiment, the case where the number of phosphor layers 4 is two is described; however, the number of phosphor layers 4 is not limited to that in the present invention, but may be three or more. Also, in the present embodiment, the case where the plurality of phosphor layers 4A and 4B are arranged so as to overlap with each other in the light incident direction is described; however, they may be arranged so as not to overlap with each other in the light incident direction (for example, a plurality of phosphor layers 4 are arranged side by side in a plane orthogonal to the light incident direction), and in this case, the color variation can be expanded in the same manner, and also if thicknesses of the respective phosphor layers 4 are individually adjusted, a color temperature change close to the blackbody locus can be achieved. Further, in the present embodiment, the case where the phosphor layer 4A containing the green phosphor 5A and the phosphor layer 4B containing the red phosphor 5B are separated from each other is described; however, by changing a mixing ratio between the green phosphor 5A and the red phosphor 5B in each of the phosphor layers 4A and 4B, the plurality of phosphor layers 4A and 4B of which the mixing ratios are different may be configured.

Also, in any of the above-described first and second embodiments, the case where the thickness of the phosphor layer 4 is changed by moving the transparent substrate 3 with the drive circuit 7 is described; however, there may be employed a configuration in which, for example, by applying an electric field to the phosphor layer 4, the thickness of the phosphor layer 4 is changed, and a method for changing the thickness of the phosphor layer 4 is not limited to one in any of the embodiments. Note that in the case of changing the thickness of the phosphor layer 4 by applying an electric field, it is necessary to use as the binder 6 a material of which a thickness is changed by the electric field.

### [Description of Reference Numerals]

- 3:: Transparent substrate (thickness changing means)
- 4:: Phosphor layer
- 5:: Phosphor
- 6:: Binder
- 7:: Drive circuit (thickness changing means)
- 10:: Wavelength converting member

## Claims

1. A wavelength converting member comprising:
a phosphor layer provided with a phosphor that converts at least part of incident light to light having a different wavelength, and a binder that holds the phosphor; and
thickness changing means adapted to change a thickness of the phosphor layer in an incident direction of the light.

2. The wavelength converting member according to claim 1, wherein the phosphor is uniformly dispersed inside the phosphor layer,

3. The wavelength converting member according to claim 1 or 2, wherein
the thickness changing means has a plurality of substrates that hold the phosphor layer in between, and changes an interval between the substrates to thereby change the thickness of the phosphor layer in the incident direction.

4. The wavelength converting member according to any one of claims 1 to 3, wherein
a plurality of the phosphor layers are provided, and arranged so as to overlap with each other in the incident direction.

5. The wavelength converting member according to any one of claims 1 to 3, wherein
a plurality of the phosphor layers are provided, and arranged so as not to overlap with each other in the incident direction.

6. The wavelength converting member according to claim 4, wherein
part of light emitted from the phosphor layer arranged in a position close to an incident surface is absorbed by the phosphor layer arranged in a position distant from the incident surface, and from the phosphor layer, light having a different wavelength is emitted.

7. An illumination device comprising: a light emitting diode; and the wavelength converting member according to any one of claims 1 to 5, wherein
the wavelength converting member converts at least part of incident light from the light emitting diode to light having a different wavelength.

## Patentansprüche

1. Wellenlängenkonversionselement aufweisend:
eine Phosphorschicht, die einen Phosphor aufweist, der zumindest einen Teil eines einfallenden Lichts in Licht mit einer anderen Wellenlänge umwandelt, und die ein Bindematerial aufweist, das den Phosphor hält; und
ein Dickenänderungsmittel, das dazu eingerichtet ist, eine Dicke der Phosphorschicht in einer Einfallsrichtung des Lichts zu ändern.

2. Wellenlängenkonversionselement nach Anspruch 1, wobei der Phosphor gleichmäßig in der Phosphorschicht verteilt ist.

3. Wellenlängenkonversionselement nach Anspruch 1 oder 2, wobei
das Dickenänderungsmittel eine Mehrzahl von Substraten aufweist, die die Phosphorschicht dazwischen halten, und das einen Abstand zwischen den Substraten verändert, um die Dicke der Phosphorschicht in der Einfallsrichtung zu ändern.

4. Wellenlängenkonversionselement nach einem der Ansprüche 1 bis 3, wobei
eine Mehrzahl von Phosphorschichten vorhanden ist und die so angeordnet sind, dass sie miteinander in der Einfallsrichtung überlappen.

5. Wellenlängenkonversionselement nach einem der Ansprüche 1 bis 3, wobei
eine Mehrzahl von Phosphorschichten vorhanden ist, die so angeordnet sind, dass sie miteinander in Einfallsrichtung nicht überlappen.

6. Wellenlängenkonversionselement nach Anspruch 4, wobei ein Teil des Lichts, das von der Phosphorschicht emittiert wird, die in einer Position nahe an einer Einfallsfläche angeordnet ist durch die Phosphorschicht absorbiert wird, die in einer Position entfernt von der Einfallsfläche angeordnet ist, wobei von der Phosphorschicht Licht emittiert wird, das eine andere Wellenlänge aufweist.

7. Beleuchtungsvorrichtung aufweisend: Eine Leuchtdiode; und ein Wellenlängenkonversionselement nach einem der Ansprüche 1 bis 5, wobei
das Wellenlängenkonversionselement zumindest einen Teil des von der Leuchtdiode einfallenden Lichts in Licht mit einer anderen Wellenlänge umwandelt.

## Revendications

1. Elément de conversion de longueur d'onde comprenant
une couche fluorescente comportant une substance luminescente qui convertit au moins une partie de la lumière incidente en une lumière ayant une longueur d'onde différente, et un liant qui tient la substance luminescente ; et
un moyen de variation d'épaisseur adapté pour faire varier l'épaisseur de la couche fluorescente dans une direction d'incidence de la lumière.

2. Elément de conversion de longueur d'onde selon la revendication 1, dans lequel la substance luminescente est dispersée uniformément à l'intérieur de la couche fluorescente.

3. Elément de conversion de longueur d'onde selon la revendication 1 ou 2, dans lequel le moyen de variation d'épaisseur comporte une pluralité de substrats qui retiennent la couche fluorescente entre eux, et fait varier un intervalle entre les substrats afin de faire varier l'épaisseur de la couche fluorescente dans la direction d'incidence.

4. Elément de conversion de longueur d'onde selon l'une quelconque des revendications 1 à 3, dans lequel il est prévu une pluralité de couches fluorescentes, agencées de façon à se chevaucher dans la direction d'incidence.

5. Elément de conversion de longueur d'onde selon l'une quelconque des revendications 1 à 3, dans lequel il est prévu une pluralité de couches fluorescentes, agencées de façon à ne pas se chevaucher dans la direction d'incidence.

6. Elément de conversion de longueur d'onde selon la revendication 4, dans lequel une partie de la lumière émise par la couche fluorescente placée en une position proche d'une surface incidente est absorbée par la couche fluorescente placée en une position distante de la surface incidente, et à partir de la couche fluorescente, une lumière ayant une longueur d'onde différente est émise.

7. Dispositif d'éclairage comprenant :
une diode électroluminescente ;
et l'élément de conversion de longueur d'onde selon l'une quelconque des revendications 1 à 5, dans lequel
l'élément de conversion de longueur d'onde convertit au moins une partie de la lumière incidente provenant de la diode électroluminescente en une lumière ayant une longueur d'onde différente.
